# EUROPEAN PATENT APPLICATION

(11) **EP 1 919 045 A2**
(43) Date of publication of application: **07.05.2008**
(21) Application number: 07115912.3
(22) Date of filing: 07.09.2007
(51) Int. Cl.: H01S 5/183

(54) **Vertical cavity surface emitting laser and fabricating method thereof**

(30) Priority: 15.09.2006 KR 20060089663
(71) Applicant: Samsung Electronics Co., Ltd., Suwon-si, Gyeonggi-Do (KR)
(72) Inventor: Kim, Young-Hyun Samsung Electronics Co., Ltd., Gyeonggi-do (KR); Kim, In Samsung Electronics Co., Ltd., Gyeonggi-do (KR); Rhee, Do-Young Samsung Electronics Co., Ltd., Gyeonggi-do (KR)
(74) Representative: Zimmer, Franz-Josef

(57) **Abstract**

A vertical cavity surface emitting laser and a method for fabricating thereof are disclosed. The laser includes: a reflective laser formed at a center portion of a contact layer, and an upper electrode that is separated from a reflective lens and that encloses the reflective lens The method for fabricating the laser includes the steps of: sequentially growing a lower reflective mirror, an oscillation region, an upper reflective mirror, and a contact layer on a upper surface of a semiconductor substrate; forming a lower electrode on a lower surface of the semiconductor substrate; forming, on the contact layer, an annular mask with a mesa shaped opening at the center portion; growing, through the opening of the mask with a mesa structure, a reflective mirror with a center and peripheral portions of different thickness; and forming annular upper electrode surrounding the reflective mirror after removing the mask.

## Description

### BACKGROUND OF THE INVENTION

### 1. Field of the Invention

The present invention relates to a laser light source, and more particularly to a vertical cavity surface emitting laser.

### 2. Description of the Related Art

A conventional edge emitting laser oscillates laser light in a parallel direction to the laminated surfaces, whereas a vertical cavity surface emitting laser oscillates laser light in a direction perpendicular to laminated surfaces. The vertical cavity surface emitting laser has a lower driving electric current value than the edge emitting laser and operates in a stable basic cross mode. In addition, as the vertical cavity surface emitting laser has small beam divergence, it has been widely used for optical communication or optical information record, or used as a holographic memory.

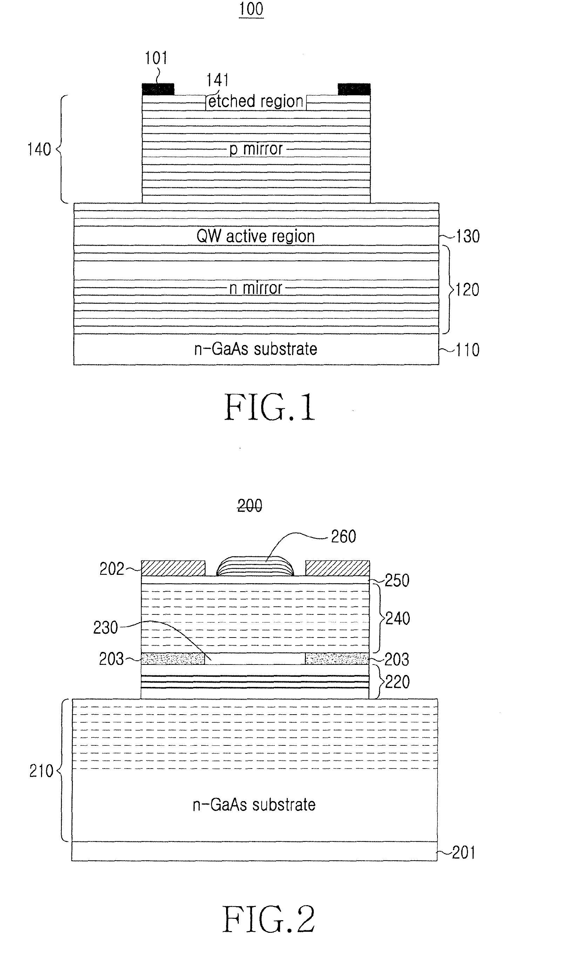

FIG. 1 is a sectional view showing a vertical cavity surface emitting laser. Referring to FIG 1, the conventional vertical cavity surface emitting laser includes a substrate, a lower reflective mirror that is gradually grown on the substrate; an oscillation region; an upper reflective mirror; a contact layer; and an upper electrode. Further, a lower electrode (not shown) is formed on the substrate to enable the application of the electricity to the vertical cavity surface emitting laser along with the upper electrode.

FIG. 1 is a sectional view showing the conventional vertical cavity surface emitting laser. Referring to FIG 1, the conventional vertical cavity surface emitting laser 100 includes an n-GaAs substrate 110, a lower reflective mirror 120 made of n-GaAs or AlGaAs, which is grown on the substrate 110, an activation layer 130 grown on the lower reflective mirror 120, and a transparent and conductive oxide layer 141 grown on the upper reflective mirror 140, etc. The activation layer 130 plays the role as an oscillation layer oscillating laser light.

The upper reflective mirror 140 may be made of p-type AlAs or AlGaAs material. In a case where the upper reflective mirror 140 is made of the p-type AlAs or AlGaAs material, p-type doping may be carried out using Zn or C in order to impregnate electric current.

There are various kinds of the above-mentioned vertical cavity surface emitting laser 100. The vertical cavity surface emitting lasers may be classified into an MBE-type vertical cavity surface emitting laser and a complex type vertical cavity surface emitting laser, according to a fabrication method.

In the MBE-type vertical cavity surface emitting laser, the laminated surfaces (upper and lower reflective mirrors and activation layer) are formed by MBE or MOCVD process. After the laminated surfaces are grown, very simple processes are carried out so as to obtain the vertical cavity surface emitting laser. Examples of the process include etching, doping with hydrogen ions, and attaching electrodes. The MBE type vertical cavity surface emitting laser has the advantage of being physically tough.

On the other hand, the complex type vertical cavity surface emitting laser is achieved by a separate vacuum deposition process of laminating SiO2, SiNx, and TiO2 or Au and Ag to form an upper reflective mirror, after surfaces (lower reflective mirror and activation layer) are laminated.

One disadvantage of the complex-type vertical cavity surface emitting laser is that it is physically weak when compared to the MBE-type vertical cavity surface emitting laser. However, the advantage of the complex-type vertical cavity surface emitting laser is that it has lower electric resistance.

As both the complex type and MBE type vertical cavity surface emitting lasers have resonant amplitude of 10~16 µm in oscillated laser light, two lasers may include laser light having a plurality of modes.

In the vertical cavity surface emitting laser 100 shown in FIG 1, in order to limit the oscillation mode of laser light, the upper reflective mirror 140 is partially etched to have different reflectance. Accordingly, it is possible to restrain the deformation of a far-field pattern.

Although the vertical cavity surface emitting laser 100 shown in FIG 1 can restrain the deformation of the far-field pattern, one disadvantage of the vertical cavity surface emitting laser 100is that the laser 100 has a difficulty in reduction of the size of the far-field pattern.
In order to address such disadvantage, numerous vertical cavity surface emitting lasers and numerous methods for fabricating the lasers have been proposed.

However, the modes of laser oscillated by most of the proposed vertical cavity surface emitting lasers do not remain constant. Instead, the modes change according to the change of input electric current. Such change in the modes with respect to the change in the input electric current pose a problem. In particular, as the modes have spatially different distributions, the far-field pattern may change when the amount of electric current is increased to improve the intensity of the oscillated laser light.

### SUMMARY OF THE INVENTION

Accordingly, the present invention has been made to solve the above-mentioned problems occurring in the prior art and provide additional advantages by providing a vertical cavity surface emitting laser which can maintain a far-field pattern stably despite changes in the applied electric current, and which can provide a narrow far-field pattern.

According to one aspect of the present invention, there is provided a vertical cavity surface emitting laser. The vertical cavity surface emitting laser includes: a reflective laser formed at a center portion of a contact layer and an upper electrode spaced from the reflective lens by a predetermined distance to enclose a circumference of the reflective lens.

According to another aspect of the present invention, there is provided a method for fabricating a vertical cavity surface emitting laser, which includes the steps of: sequentially growing a lower reflective mirror, an oscillation region, an upper reflective mirror, and a contact layer on a semiconductor substrate after forming a lower electrode on a lower surface of the semiconductor substrate; forming an annular mask, which has a mesa shaped opening at a center portion of the mask, on the contact layer; growing the reflective mirror, which has center and peripheral portions with a different thickness, through the opening of the mask with a mesa structure; and forming annular upper electrode enclosing a circumference of the reflective mirror after removing the mask.

### BRIEF DESCRIPTION OF THE DRAWINGS

The features and advantages of the present invention will be more apparent from the following detailed description taken in conjunction with the accompanying drawings, in which:
FIG. 1 is a sectional view showing a vertical cavity surface emitting laser according to the conventional art;
FIG. 2 is a sectional view showing a vertical cavity surface emitting laser according to one aspect of the present invention;
FIG. 3 is a graph illustrating a relationship of the thickness and the reflectance corresponding to the thickness of a reflective mirror shown in FIG 2;
FIG 4 is a sectional view showing an oscillation region in the vertical cavity surface emitting laser shown in FIG 2;
FIG. 5 is a sectional view showing a mask in which an inner side surface has a mesa structure formed on a contact layer in order to grow the reflective lens shown in FIG 2;
FIG 6 is a graph illustrating a mode for selecting a laser light depending on the reflective lens shown in FIG 2; and
FIG. 7 is a view illustrating a relationship between a far-field pattern of emitted laser light and the reflective lens shown in FIG 2.

### DETAILED DESCRIPTION OF THE INVENTION

Hereinafter, several aspects of the present invention will be described in detail with reference to the accompanying drawings. For the purposes of clarity and simplicity, detailed description of known functions and configurations is omitted as such description may make the subject matter of the present invention unclear.

FIG. 2 is a sectional view showing a vertical cavity surface emitting laser according to the first aspect of the present invention. Referring to FIG 2, the vertical cavity surface emitting laser 200 according to the present invention includes a contact layer 250, a reflective lens 260 formed at the center portion of the contact layer 250, an upper electrode 202 spaced from the reflective lens by a desired distance and enclosing a circumference of the reflective lens, a lower reflective mirror 220, an upper reflective mirror 240, an oscillation region 230, and a lower electrode 201.

The contact layer 250 may be formed by laminating p-type GaAs. The substrate 210 may be made of n-GaAs. The lower reflective mirror 220 is formed by growing n-GaAs or AlGaAs on the substrate. The upper reflective mirror 240 may be made of p-AlAs or AlGaAs. If the upper reflective mirror is made of AlAs and/or AlGaAs, p-type doping is carried out using Zn or C.

The lower reflective mirror 220 may be formed by growing a multilayered n-type reflective mirror by MOCVD or MBE. The lower reflective mirror 220 may be formed by alternately growing AlGaAs with high refractive index and with the thickness of 800Å and AlGaAs with low refractive index and with the thickness of 1000Å, by 35 to 45 layers. Note that the number 35 to 45 represents the number of the laminated layers, where each laminated layer includes one high refractive index layer and one low refractive index layer.

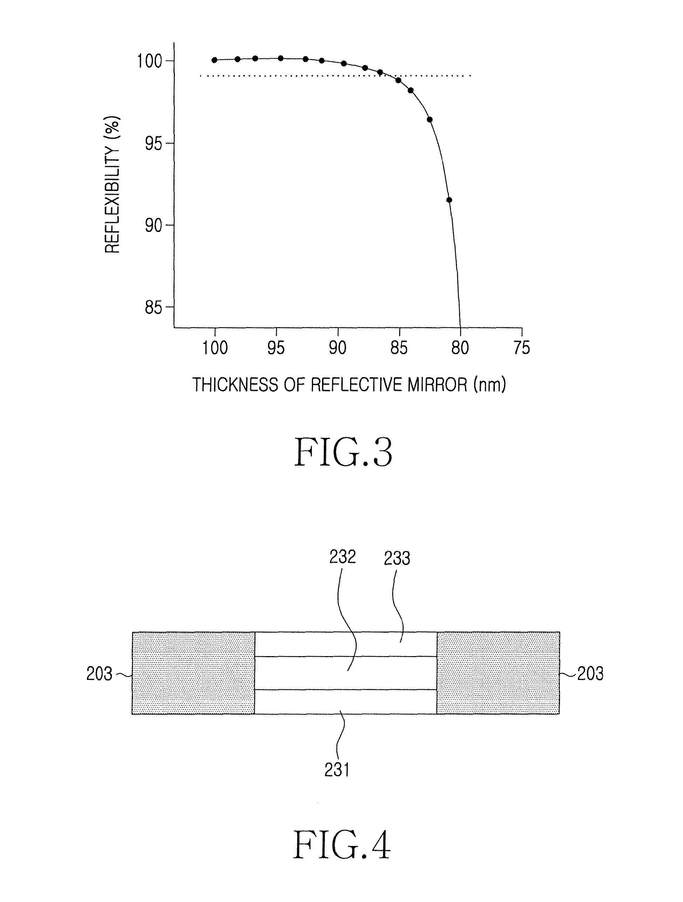

FIG. 4 is a sectional view showing an oscillation region 230 in the vertical cavity surface emitting laser 200 shown in FIG 2. The oscillation region 230 includes an activation layer 232 that has a multi-quantum well structure and that is grown between lower and lupper clads 231 and 233. Light generated in the oscillation region 230 resonates between the upper and lower mirrors 220 and 240, and the generated light is output as laser light. Electric current isolation layers 203 are disposed on both sides of the oscillation region 230.

The lower clad 231 is grown on the lower reflective mirror 220, and the upper clad 233 is disposed below the upper reflective mirror 240. The activation layer 232 may be made of GaAs material.

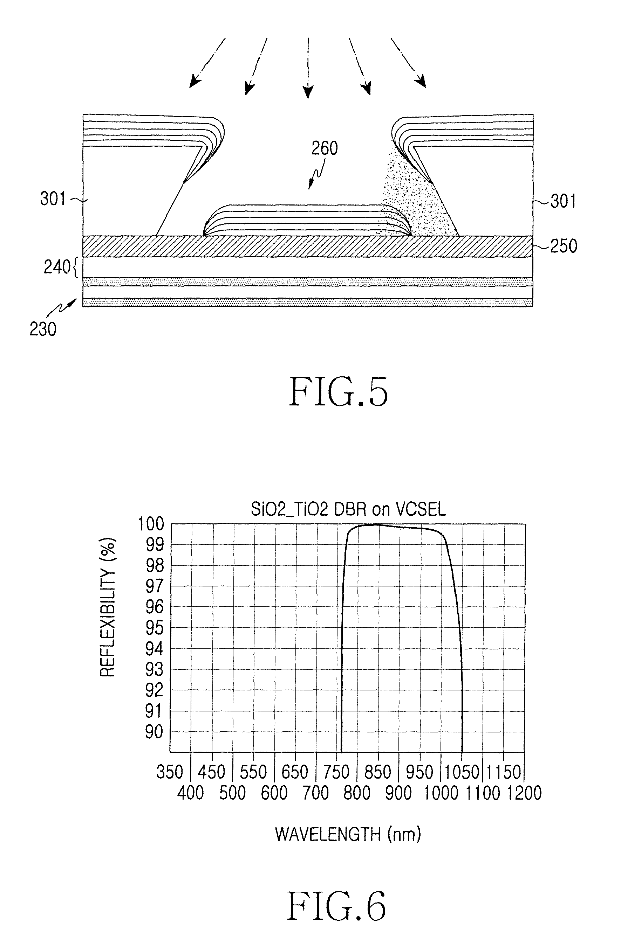

FIG 5 is a sectional view showing a mask in the form of a reverse mesa, the mask which grows the reflective lens 260 shown in FIG 2 in the form of a mesa structure. In the reflective lens 260, the central portion and the peripheral portions may have different height.

The mask 301 is formed on the contact layer 250 by photolithography, and the mask 301 has an opening at the central portion to form the reflective lens 260. The sidewall of the mask 301 has a reverse mesa structure in which it is tapered from the contact layer 250 to the central portion. As a result, the space generated by the inner sidewall of the mask 301 has a mesa structure.

After the mask 301 is formed, the reflective lens 260 is grown by depositing a plurality of dielectric materials in multi-layers. The dielectric materials may include SiO2 or TiO2. As the deposition thickness of the reflective lens 260 is partially limited by the mask, the reflective lens may have a desired curvature.

For Example, if the thickness of the reflective lens is about 1.6~2.0 µm, the mask 301 should have a thickness of 2.5~10 µm. As the height of the mask 301 is designed to be higher than the reflective lens 260, the formed reflective lens 260 may have one thickness at the central portion and another, different thickness at the peripheral portion. The reflective lens 260 is formed by alternately laminating SiO2 of 1500Å and TiO2 of 780 Å in 6 or 8 layers.

Consequently, the reflective lens 260 has the central portion with a thickness of about 1.6~2.0 µm, and the peripheral portion with a thickness of about 0 µm. The thickness of the reflective lens varies continuously such that the reflective lens has a smoothly curved surface. After the reflective lens 260 is grown, the mask 301 is removed by photo-resist stripper, such as NMP or Acetone.

The reflective lens 260 may be grown using a material with higher refractive index and a material with lower refractive index. In addition, the reflective lens 260 may be of a material with low or no absorbance in the wavelength of the oscillation laser light. Available dielectric materials include SiO2/SiNx, Al2O3/TiO2, Al2O3/SiNx, SiO2/Ta2O5, and the like.

FIG 6 is a graph illustrating the selection of a mode of laser light depending on the reflective lens 260 shown in FIG 2. In addition, FIG 6 shows a spectrum characteristic obtained by measuring the in a wavelength band of the reflective lens 260. Referring to the graph illustrated in FIG 6, the reflective lens 260 has a reflectance of 99 percent in the wavelength band of about 750~1050 nm. The reflectance and the wavelength band of the reflective lens 260 may be differently set depending on the wavelength of oscillation light of the vertical cavity surface emitting laser.

FIG 3 is a graph illustrating a relationship between the thickness and the reflectance of the reflective lens 260 shown in FIG 2. As shown in FIG 3, if the thickness of the reflective lens is reduced to 85%, the reflectance of the reflective lens 260 is decreases gradually to about 98%. However, if the thickness of the reflective lens is reduced to 80%, the reflectance of the reflective lens 260 is decreases rapidly to below 85%.

The reflective lens 260 according to the present invention has reflectance difference at the central portion of the reflective lens 260 and the peripheral portion of the reflective lens 260 according to the change in thickness. Accordingly, the central portion and peripheral portion of the reflective lens have different reflectance.

If the reflective lens 260 has reflectance below 98%, with respect to the light in a wavelength band to be oscillated, the laser light cannot be easy oscillated. As shown in FIG 3, if the reflective lens has a thickness smaller than 80% of an original thickness, the reflectance of the reflective lens is below 85%. Therefore, the laser light does not oscillate.

As the laser light of a mode firstly generated by threshold current is emitted from the central portion of the reflective lens, the reflective lens 260 according to the present invention may oscillate laser light selectively, to include only a mode located at the central portion of the far-field pattern. Therefore, the present invention is capable of oscillating, as laser light, only the mode in the central portion of the far-field pattern, even though the amount of applied electric current increases.

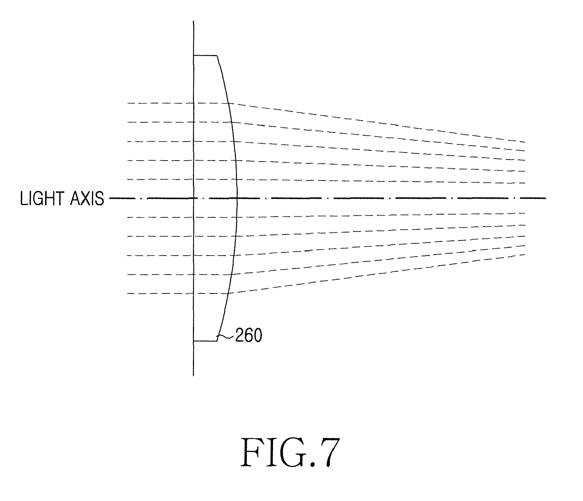

Further, as the reflective lens 260, as shown in FIG 7, has such a curvature that the peripheral portion has smaller thickness than the central portion, the reflective lens 260 converges emitted laser light. The reflective lens 260 has curvature and size set to have a focal length.

A method for fabricating the vertical cavity surface emitting laser according to the present invention includes the steps of sequentially growing a lower reflective mirror, an oscillation region, an upper reflective mirror, and a contact layer, after forming a lower electrode on a lower surface of a semiconductor substrate; forming an annular mask with a mesa-shaped opening at the center portion of the annular mask on the contact layer; growing a reflective mirror having a center portion and a peripheral portion which have different thicknesses from each other due to the opening of the mesa structure of the mask; and forming an annular upper electrode enclosing a circumstance of the reflective mirror after removing the mask.

The present invention further includes a reflective lens with a curvature such that the thickness decreases gradually from the center portion to the peripheral portion of the reflective lens. Therefore, the present invention is capable of oscillating the laser light of desired mode, as the mode of laser light emitted during application of threshold current is formed at the center portion of the reflective lens.

In addition, as the reflective lens of the present invention is grown to have thickness decreasing from the center portion to the peripheral portion, the far-field pattern of the oscillated laser light may be reduced.

Further, as the focus of the laser light may be adjusted according to the curvature of the reflective lens, the present invention allows the fabrication of the vertical cavity surface emitting laser having different focusing distances with ease.

While the invention has been shown and described with reference to certain preferred embodiments thereof, it will be understood by those skilled in the art that various changes in form and details may be made therein without departing from the spirit and scope of the invention as defined by the appended claims.

## Claims

1. A vertical cavity surface emitting laser (200) comprising:
a contact layer (250);
a reflective lens (260) being disposed at a center portion of the contact layer (250); and
an upper electrode (202) being separated from the reflective lens (260) by a predetermined distance and being configured to surround the reflective lens (260).

2. The vertical cavity surface emitting laser (200) as claimed in claim 1, further comprising:
a substrate (210);
a lower reflective mirror (220) being disposed on the substrate (210);
an upper reflective mirror (240) being disposed on the lower reflective mirror (220); and
an oscillation region (230) being interposed between the upper and lower reflective mirrors (240, 220), the oscillation region (230) being configured to oscillate and output laser light to the upper reflective mirror (240).

3. The vertical cavity surface emitting laser (200) as claimed in claim 2, further comprising a lower electrode (201) disposed on a lower portion of the substrate (210).

4. The vertical cavity surface emitting laser (200) as claimed in claim 2 or 3, wherein the lower reflective mirror (220) is a multilayered n-type reflective mirror grown by one of MOCVD and MBE.

5. The vertical cavity surface emitting laser (200) as claimed in claim 4, wherein the lower reflective mirror (220) comprises multiple layers of alternately laminated GaAs and AlGaAs.

6. The vertical cavity surface emitting laser (200) as claimed in any one of claims 2 to 5, wherein the oscillation region (230) comprises
a lower clad (231) being disposed on the lower reflective mirror (220);
an activation layer (232) being disposed on the lower clad (231); and
an upper clad (233) being disposed on the activation layer (232).

7. The vertical cavity surface emitting laser (200) as claimed in claim 6, further comprising an electric current isolation layer (203) disposed at a lateral side of the oscillation region (230).

8. The vertical cavity surface emitting laser as claimed in claim 6 or 7, wherein the activation layer (232) is a GaAs based material.

9. The vertical cavity surface emitting laser (200) as claimed in any one of claims 2 to 8, wherein the upper reflective mirror (240) is a p-type reflective mirror including AlAs and AIGaAs layer and comprising a multiple layers of alternately laminated AlAs and AIGaAs.

10. The vertical cavity surface emitting laser (200) as claimed in any one of claims 1 to 9, wherein the contact layer (250) is a p-type GaAs.

11. The vertical cavity surface emitting laser (200) as claimed in any one of claims 1 to 10, wherein center and peripheral portions of the reflective lens (260) have different height.

12. The vertical cavity surface emitting laser (200) as claimed in claim 11, wherein the reflective lens (260) comprises layers of alternately formed dielectric materials with different refractive indices.

13. A method for fabricating a vertical cavity surface emitting laser (200), the method comprising the steps of
sequentially growing a lower reflective mirror (220), an oscillation region (230), an upper reflective mirror (240), and a contact layer (250) on a semiconductor substrate (210), after forming a lower electrode (201) on a lower surface of the semiconductor substrate (210);
forming an annular mask (301), which has a mesa shaped opening at a center portion, on the contact layer (250);
growing a reflective lens (260), which has center and peripheral portions with a different thickness, through the opening of the mask (301) with a mesa structure; and
forming an annular upper electrode (202) surrounding the reflective lens (260), after removing the mask (301).

14. The method as claimed in claim 13, wherein the sidewall of the opening of the mask (301) is etched in a reverse mesa structure.

15. The method as claimed in claim 13 or 14, wherein the reflective lens (260) is grown so as to have a predetermined curvature and a thickness gradually decreasing from the center portion to the peripheral portion of the reflective lens (260).
